# FASCICULE DE BREVET EUROPEEN

(11) **EP 4 395 170 B1**
(45) Date de publication et mention de la délivrance du brevet: **08.07.2026**
(21) Numéro de dépôt: 23220239.0
(22) Date de dépôt: 27.12.2023
(51) Int. Cl.: H03H 7/48

(54) **DISPOSITIF DE TRAITEMENT DE SIGNAUX ÉLECTRIQUES**
VORRICHTUNG ZUR VERARBEITUNG ELEKTRISCHER SIGNALE
DEVICE FOR PROCESSING ELECTRICAL SIGNALS

(30) Priorité: 27.12.2022 FR 2214534
(43) Date de publication de la demande: 03.07.2024
(73) Titulaire: THALES, 92190 Meudon (FR)
(72) Inventeur: ESNAULT, Matthieu, 49309 CHOLET (FR); FOUGERAY, Germain, 49309 CHOLET (FR); GUERN, Pierre, 49309 CHOLET (FR)
(74) Mandataire: Lavoix

(56) Documents cités:
- EP-A1- 0 124 423
- US-A- 4 234 854
- US-A1- 2019 081 399
- ELSBURY M M ET AL: "Broadband Lumped-Element Integrated N-Way Power Dividers for Voltage Standards", IEEE TRANSACTIONS ON MICROWAVE THEORY AND TECHNIQUES, IEEE, USA, vol. 57, no. 8, 1 August 2009 (2009-08-01), pages 2055 - 2063, XP011271059, ISSN: 0018-9480, DOI: 10.1109/TMTT.2009.2025464
- ADEL A M SALEH: "Planar Electrically Symmetric n-Way Hybrid Power Dividers/Combiners", IEEE TRANSACTIONS ON MICROWAVE THEORY AND TECHNIQUES, IEEE, USA, vol. MTT-28, no. 6, 1 June 1980 (1980-06-01), pages 555 - 563, XP001368588, ISSN: 0018-9480

## Description

La présente invention concerne un dispositif de traitement de signaux électriques à traiter, selon le préambule de la revendication 1.

De tels dispositifs de traitement sont par exemple utilisés dans un radiogoniomètre en association avec une pluralité d'émetteurs/récepteurs. En particulier, dans un radiogoniomètre, un tel dispositif permet de combiner les signaux reçus par une pluralité de récepteurs.

Pour que le radiogoniomètre puisse déterminer de manière précise la direction d'arrivée des signaux reçus, il est nécessaire de procéder à un calibrage de ses récepteurs. Pour ce faire, il est connu d'envoyer dans les récepteurs un signal de calibrage divisé par le dispositif de traitement et distribué à chacun des récepteurs. Pour que le calibrage soit précis, la différence de phase et la différence de gain engendrées par le dispositif de traitement entre chacun des signaux de calibrage reçu par les récepteurs doivent être les plus faibles possible.

Or, certains radiogoniomètres présentent un grand nombre de récepteurs, notamment supérieur ou égal à 5. Les dispositifs de traitement de l'état de la technique, à 5 entrées ou sorties proposant des performances en différence de phase et en différence de gain suffisantes présentent un encombrement important.

L'article *«* Broadband Lumped-Element Integrated N-Way Power Dividers for Voltage Standards » de Elsbury et al. divulgue un diviseur de puissance.

US 2019/081399 A1 divulgue un circuit de traitement de signaux.

L'article « Planar Electrically Symmetric n-Way Hybid Power Dividers/Combiners » de Saleh et al. divulgue un diviseur/combineur de puissance.

EP 0 124 423 A1 divulgue un amplificateur hyperfréquence de puissance.

La publication ELSBURY M M ET AL: "Broadband Lumped-Element Integrated N-Way Power Dividers for Voltage Standards", IEEE TRANSACTIONS ON MICROWAVE THEORY AND TECHNIQUES, IEEE, USA, vol. 57, no. 8, 1 août 2009 (2009-08-01), pages 2055-2063, XP011271059, ISSN: 0018-9480, DOI: 10.1109/TMTT.2009.2025464 décrit un dispositif conforme au préambule de la revendication 1:
Un but de l'invention est de fournir un dispositif de traitement qui permette d'obtenir une différence de phase et une différence de gain les plus faibles possibles entre des signaux traités transitant par de nombreuses deuxièmes bornes tout en présentant un encombrement réduit.

A cet effet, l'invention concerne un dispositif de traitement du type susmentionné, et selon la partie caractérisante de la revendication 1.

Les circuits intégrés de traitement de signaux de chaque étage engendrent de faibles différences de phase et de gain sur les signaux qu'ils traitent et présentent un encombrement minime.

Par conséquent, la mise en réseau de ces circuits intégrés suivant le montage revendiqué permet alors d'obtenir des différences de phase et de gain faibles entre les nombreuses deuxièmes bornes et permet d'obtenir un dispositif présentant un encombrement faible.

Suivant des modes particuliers de réalisation, le dispositif de traitement est selon l'une ou plusieurs des revendications 2 à 8, prises isolément ou selon toute combinaison techniquement envisageable.

D'autres aspects et avantages de l'invention apparaîtront à la lecture de la description qui suit, donnée à titre d'exemple et faite en référence aux dessins annexés, dans lesquels :
- La Figure 1 est une représentation schématique simplifiée d'un exemple de dispositif de traitement selon l'invention ;
- la Figure 2 est un exemple de réalisation du dispositif de traitement de la Figure 1 ;
- la Figure 3 est une représentation schématique simplifiée en vue de côté d'une portion du dispositif de traitement de la Figure 2 ;
- la Figure 4 est une représentation schématique simplifiée en vue de dessus de la portion du dispositif de traitement de la Figure 3.

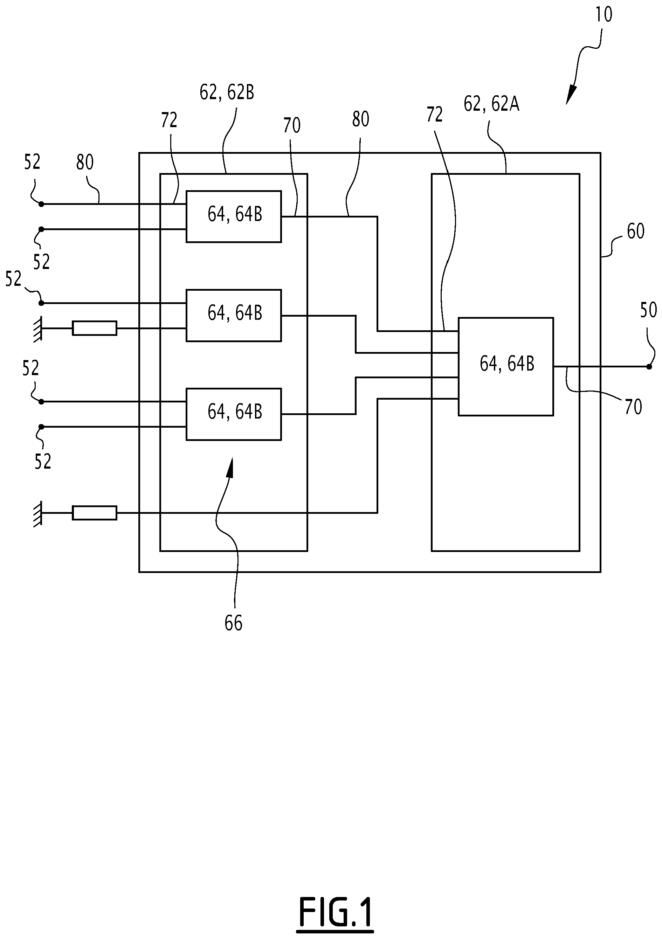

En référence aux Figures 1 à 4, on décrit un dispositif 10 de traitement de signaux électriques à traiter.

Par traitement, on entend la division d'un signal électrique à diviser en signaux électriques divisés ou une combinaison de signaux électriques à combiner en un signal électrique combiné.

Par division d'un signal électrique, on entend la reproduction d'un signal électrique à reproduire en signaux électriques reproduits, présentant des caractéristiques sensiblement identiques au signal électrique à reproduire.

Notamment, les signaux reproduits sont identiques en fréquence et en phase au signal à reproduire mais présentent un niveau (autrement dit une puissance) plus faible.

Par combinaison d'un signal électrique, on entend la combinaison de signaux électriques à combiner en un signal électrique combiné, présentant des caractéristiques sensiblement identiques aux signaux électriques à combiner.

Notamment, le signal combiné est identique en fréquence et en phase aux signaux à combiner mais présente un niveau (autrement dit une puissance) plus élevée.

Les signaux électriques sont, par exemple des signaux radiofréquence, notamment des signaux hyperfréquence. Les signaux hyperfréquence présentent de préférence une fréquence comprise entre 2 MHz et 8 GHz.

Le dispositif de traitement 10 comprend un support 20, un substrat 40 recouvrant le support 20, une première borne 50, N deuxième bornes 52 et un module 60 de traitement de signaux électriques.

Avantageusement, le dispositif de traitement 10 comprend en outre des lignes 80 de transmission de signaux électriques.

Le support 20 est par exemple une plaque de ROGERS RO4350^{™} s'étendant sensiblement selon un plan P sensiblement orthogonal à une direction D et présentant une épaisseur E1 mesurée selon la direction D, comprise entre 25µm et 1cm. Avantageusement, le support 20 est réalisé en un matériau de type diélectrique. Par exemple, le support 20 a une forme de disque.

Le support 20 présente une surface de support 22 sur laquelle le substrat 40, le module de traitement 60, la première borne 50, les deuxièmes bornes 52 et les lignes de transmission 80 s'étendent.

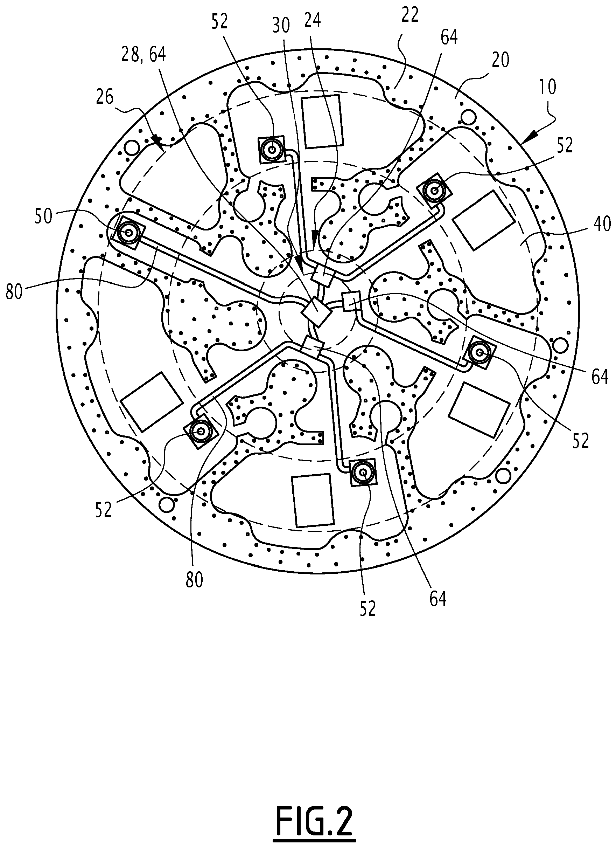

La surface de support 22 présente une surface comprise entre 2 cm² et 200 cm². Selon l'exemple illustré sur les Figures 1 et 2, la surface du support 22 présente une surface inférieure à 4 cm².

En référence à la Figure 2, la surface de support 22 présente une portion centrale 24 en regard de laquelle des circuits intégrés 64 de M étages de traitement 62 du module de traitement 60 sont regroupés.

La surface de support 22 présente en outre une portion annulaire 26 centrée sur la portion centrale 24, en regard de laquelle sont agencées la première borne 50 et les deuxièmes bornes 52.

La portion centrale 24 de la surface du support 22 présente :
- une position centrale 28 sur laquelle un premier circuit intégré 64 est agencé ; et
- M-1 cercles concentriques 30 centrés sur la position centrale.

Lorsque M est supérieur ou égal à 3 :
- pour P un entier compris entre 1 et M-2, le rayon du P+1-ième cercle concentrique 30 est supérieur au rayon du P-ième cercle concentrique 30 ;
- pour L un entier compris entre 1 et M-1, des L+1-ième circuits intégrés d'un L+1-ième étage de traitement 62 du module de traitement 60 sont agencés sensiblement sur le L-ième cercle concentrique 30.

Le substrat 40 recouvre au moins partiellement le support 20, notamment la surface de support 22.

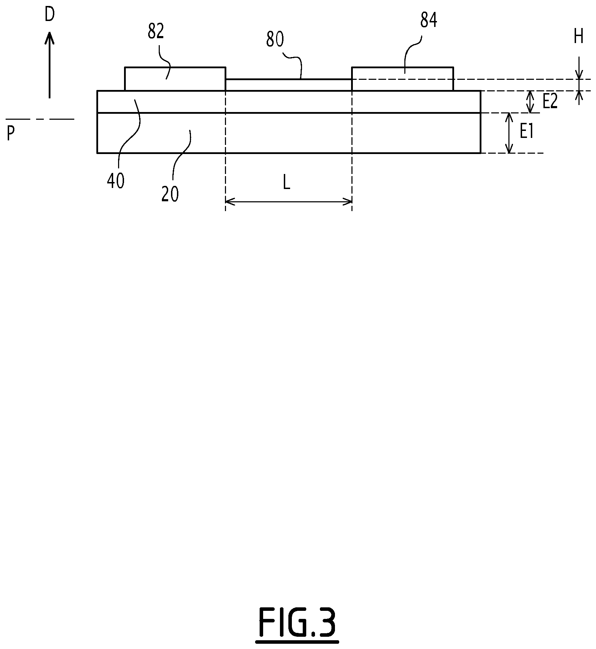

Avantageusement, en référence à la Figure 3, le substrat 40 présente une épaisseur E2, mesurée selon la direction D, comprise entre 0,1 mm et 10,0 mm.

Encore avantageusement, le substrat 40 est réalisé en un matériau présentant une permittivité relative comprise entre 1,1 et 10,0. La permittivité relative du substrat est par exemple sensiblement égale à 3,7.

Encore avantageusement, le substrat 40 est réalisé en un matériau comprenant de la résine époxy et des fibres de verre.

La première borne 50 est agencée sur le substrat 40 et est connectée au module de traitement 60.

La première borne 50 est apte à recevoir un signal électrique à traiter par le module de traitement 60 ou à distribuer un signal électrique traité par le module de traitement 60.

Comme illustré sur l'exemple de la Figure 2, la première borne 50 est agencée en regard de la portion annulaire 26 de la surface du support 22.

Les N deuxièmes bornes 52 sont agencées sur le substrat 40.

Chaque deuxième borne 52 est connectée au module de traitement 60 et est apte à recevoir un signal électrique à traiter par le module de traitement 60 ou à distribuer un signal électrique traité par le module de traitement 60.

N est un entier supérieur ou égal à 5.

Selon l'exemple illustré sur les Figures 1 et 2, N est égal à 5.

Chaque deuxième borne 52 est connectée à un M-ième circuit intégré 64 de traitement de signaux électriques d'un M-ième étage de traitement 62 de signaux électriques appartenant au module 60 de traitement des signaux électriques.

Comme illustré sur l'exemple de la Figure 2, les deuxièmes bornes 52 sont agencées en regard de la portion annulaire 26 de la surface du support 22.

Encore en référence à l'exemple de la Figure 2, les deuxièmes bornes 52 ainsi que la première borne 50 sont réparties uniformément angulairement autour de la portion centrale 28 de la surface du support 22.

Le module 60 de traitement des signaux électriques est agencé sur le substrat 40.

Le module de traitement 60 comprend M étages 62 de traitement de signaux électriques successivement connectés entre la première borne 50 et les deuxièmes bornes 52.

M est un entier supérieur ou égal à 2.

Selon l'exemple illustré sur les Figures 1 et 2, M est égal à 2.

Un premier étage de traitement 62, 62A comprend un premier circuit intégré 64A de traitement de signaux électriques agencé sur le substrat 40 et connecté à la première borne 50.

Pour K un entier compris entre 2 et M, le K-ième étage 62 comprend au moins un ensemble 66 de K-ième circuits intégrés 64 de traitement de signaux électriques agencés sur le substrat 40.

Les K-ième circuits intégrés 64 de respectivement chaque ensemble 66 sont connectés à un K-1-ième circuit intégré 64 respectif du K-1-ième étage 62.

Selon l'exemple illustré sur les Figures 1 et 2, le deuxième étage 62B comprend un unique ensemble 66 de deuxièmes circuits intégrés 64B de traitement de signaux électriques.

Les deuxièmes circuits intégrés 64B de l'unique ensemble 66 du deuxième étage 62B sont connectés au circuit intégré 64A du premier étage 62A.

Toujours selon l'exemple illustré sur les Figures 1 et 2, au moins un deuxième circuit intégré 64B, de manière générale un M-ième circuit intégré 64, est connecté à la masse par l'intermédiaire d'une résistance, notamment d'une résistance de 50 ohms.

Avantageusement, les circuits intégrés 64 de traitement de signaux électriques sont des circuits intégrés monolithiques hyperfréquence configurés pour diviser ou combiner des signaux électriques, notamment des signaux hyperfréquence.

Notamment, les circuits intégrés monolithiques hyperfréquence présentent des circuits de traitement du signal du type résistif et/ou du type Wilkinson. En outre, les circuits intégrés monolithiques hyperfréquence utilisés présentent des différences de phase et de gain entre voies faibles dans la bande de fréquence ciblée.

Chaque circuit intégré 64 de traitement de signaux électrique comprend un premier point 70 de connexion à un circuit intégré 64 d'un étage 62 inférieur ou à la première borne 50 et une pluralité de second points 72 de connexion à des circuits intégrés 64 d'un étage 62 supérieur ou à des deuxièmes bornes 52.

Sur l'exemple des Figures 1 et 2, le premier circuit intégré 64A du premier étage de traitement 62A comprend quatre seconds points 72 de connexion aux circuits intégrés 64B du deuxième étage 62B et un premier point de connexion 70 à la première borne 50.

Toujours sur l'exemple des Figures 1 et 2, les deuxièmes circuits intégrés 64B du deuxième étage de traitement 62B comprennent chacun un premier point de connexion 70 au premier circuit intégré 64A du premier étage 62A et deux seconds points 72 de connexion à une deuxième borne 52 ou à la masse par l'intermédiaire d'une résistance.

Chaque circuit intégré 64 comprend au plus quatre seconds points de connexion 72.

Chaque circuit intégré 64 est tel que les signaux électriques transitant par ses seconds points de connexion 72 présentent :
- une différence de phase inférieure à 5° lorsque les signaux électriques présentent une fréquence comprise entre 2 MHz et 5 GHz ;
- une différence de phase inférieure à 10° lorsque les signaux électriques présentent une fréquence comprise entre 5 GHz et 8 GHz ; et
- une différence de gain inférieure à 0,4 dB.

Notamment, chaque circuit intégré monolithique hyperfréquence présente une surface projetée sur le plan P inférieure ou égale à 9 mm2.

En référence aux Figures 1 à 4, les lignes 80 de transmission de signaux électriques sont gravées sur le substrat 40 et chaque ligne 80 s'étend entre un premier élément électronique 82 et un second élément électronique 84.

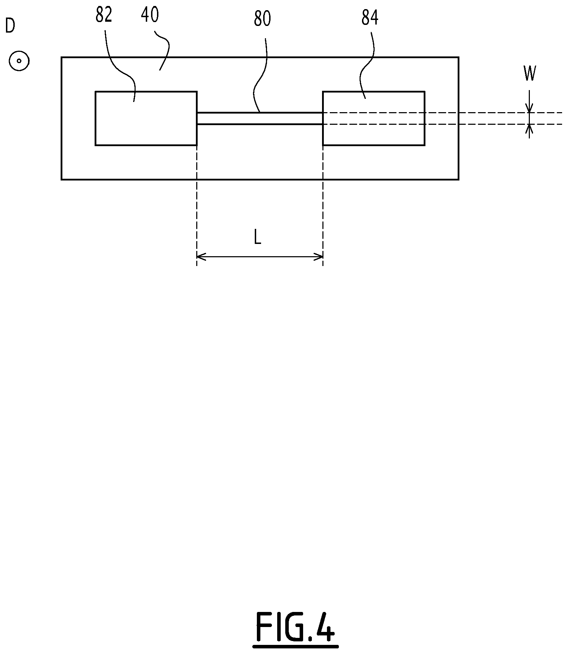

En référence aux Figures 3 et 4, chaque ligne de transmission 80 présente une longueur L mesurée entre les premier 82 et deuxième 84 éléments électroniques comprise entre 0,1 mm et 10 cm.

En référence à la Figure 4, chaque ligne de transmission 80 présente une largeur W comprise entre 0,1 mm et 10,0 mm.

En référence à la Figure 3, chaque ligne de transmission 80 présente une épaisseur H comprise entre 1 µm et 1mm.

Le premier élément électronique 82 est un circuit intégré 64 et le deuxième élément électronique 84 est un autre circuit intégré 64, la première borne 50 ou une deuxième borne 52.

Dans ce qui suit, on décrit un exemple particulier dans lequel le dispositif de traitement 10 est un dispositif de division d'un signal électrique à diviser.

Le module de traitement 60 est alors un module de division configuré pour diviser le signal électrique à diviser en signaux électriques divisés.

La première borne 50 est destinée à recevoir le signal électrique à diviser.

Chaque deuxième borne 52 est destinée à distribuer un signal électrique divisé.

Le module de division comprend M étages 62 de division de signaux.

Le premier étage 62 de division comprend un premier circuit intégré 64 de division de signal électrique configuré pour diviser le signal électrique à diviser reçu par la première borne 50 en signaux électrique divisés.

Pour K un entier compris entre 2 et M-1, chacun des K-ièmes circuits intégrés 64 de division du K-ième étage 62 sont configurés pour diviser un signal électrique à diviser reçu depuis un K-1-ième circuit intégré 64 de division du K-1-ième étage 62 en signaux électriques divisés.

Chaque M-ième circuit intégré 64 de division du M-ième étage 62 étant configuré pour diviser un signal électrique à diviser reçu depuis un circuit intégré 64 du M-1-ième étage 62 en signaux électriques divisés et transmettre un desdits signaux électriques divisés à au moins une deuxième borne 52.

Dans ce qui suit, on décrit un exemple particulier dans lequel le dispositif de traitement 10 est un dispositif de combinaison de signaux électriques à combiner.

Le module de traitement 60 est alors un module de combinaison configuré pour combiner les signaux électriques à combiner en un signal électrique combiné.

La première borne 50 est destinée à distribuer le signal électrique combiné.

Chaque deuxième borne 52 est destinée à recevoir un signal électrique à combiner.

Le module de combinaison 60 comprend M étages 62 de combinaison de signaux.

Chaque M-ième circuit intégré 64 de combinaison du M-ième étage étant configuré pour combiner des signaux électriques à combiner reçus depuis au moins une deuxième borne 52 en un signal électrique combiné.

Pour K un entier compris entre 2 et M-1, chacun des K-ièmes circuits intégrés 64 du K-ième étage 62 étant configuré pour combiner des signaux électriques à combiner reçus depuis respectivement des K+1-ièmes circuits intégrés 64 de combinaison du K+1-ième étage 62 en un signal électrique combiné.

Le premier circuit intégré 64 de combinaison du premier étage 62 de combinaison est configuré pour combiner des signaux électriques à combiner reçus depuis au moins un deuxième circuit intégré 64 de combinaison du deuxième étage 62 en un signal électrique combiné et transmettre ledit signal électrique combiné à la première borne 50.

Grâce à l'invention, il est possible d'obtenir un dispositif de traitement de signaux électrique tel que les signaux électriques transitant par un grand nombre de deuxièmes bornes présentent :
- une différence de phase inférieure à 5° lorsque les signaux électriques présentent une fréquence comprise entre 2 MHz et 5 GHz ;
- une différence de phase inférieure à 10° lorsque les signaux électriques présentent une fréquence comprise entre 5 GHz et 8 GHz ; et
- une différence de gain inférieure à 0,4 dB ;
pour des signaux électriques dont la puissance monte jusqu'à 27 dBm.

L'invention permet en outre d'obtenir ces caractéristiques avantageuses tout en limitant l'encombrement du dispositif. En effet, la surface du support 22 présente une surface inférieure à 4 cm² ce qui est très inférieure à celle des dispositifs de l'état de la technique.

Dans ce qui suit, on décrit un exemple particulier dans lequel le dispositif de traitement 10 est un dispositif de division d'un signal électrique à diviser.

Le module de traitement 60 est alors un module de division configuré pour diviser le signal électrique à diviser en signaux électriques divisés.

La première borne 50 est destinée à recevoir le signal électrique à diviser.

Chaque deuxième borne 52 est destinée à distribuer un signal électrique divisé.

Le module de division comprend M étages 62 de division de signaux.

Le premier étage 62 de division comprend un premier circuit intégré 64 de division de signal électrique configuré pour diviser le signal électrique à diviser reçu par la première borne 50 en signaux électrique divisés.

Pour K un entier compris entre 2 et M-1, chacun des K-ièmes circuits intégrés 64 de division du K-ième étage 62 sont configurés pour diviser un signal électrique à diviser reçu depuis un K-1-ième circuit intégré 64 de division du K-1-ième étage 62 en signaux électriques divisés.

Chaque M-ième circuit intégré 64 de division du M-ième étage 62 étant configuré pour diviser un signal électrique à diviser reçu depuis un circuit intégré 64 du M-1-ième étage 62 en signaux électriques divisés et transmettre un desdits signaux électriques divisés à au moins une deuxième borne 52.

Dans ce qui suit, on décrit un exemple particulier dans lequel le dispositif de traitement 10 est un dispositif de combinaison de signaux électriques à combiner.

Le module de traitement 60 est alors un module de combinaison configuré pour combiner les signaux électriques à combiner en un signal électrique combiné.

La première borne 50 est destinée à distribuer le signal électrique combiné.

Chaque deuxième borne 52 est destinée à recevoir un signal électrique à combiner.

Le module de combinaison 60 comprend M étages 62 de combinaison de signaux.

Chaque M-ième circuit intégré 64 de combinaison du M-ième étage étant configuré pour combiner des signaux électriques à combiner reçus depuis au moins une deuxième borne 52 en un signal électrique combiné.

Pour K un entier compris entre 2 et M-1, chacun des K-ièmes circuits intégrés 64 du K-ième étage 62 étant configuré pour combiner des signaux électriques à combiner reçus depuis respectivement des K+1-ièmes circuits intégrés 64 de combinaison du K+1-ième étage 62 en un signal électrique combiné.

Le premier circuit intégré 64 de combinaison du premier étage 62 de combinaison est configuré pour combiner des signaux électriques à combiner reçus depuis au moins un deuxième circuit intégré 64 de combinaison du deuxième étage 62 en un signal électrique combiné et transmettre ledit signal électrique combiné à la première borne 50.

Grâce à l'invention, il est possible d'obtenir un dispositif de traitement de signaux électrique tel que les signaux électriques transitant par un grand nombre de deuxièmes bornes présentent :
- une différence de phase inférieure à 5° lorsque les signaux électriques présentent une fréquence comprise entre 2 MHz et 5 GHz ;
- une différence de phase inférieure à 10° lorsque les signaux électriques présentent une fréquence comprise entre 5 GHz et 8 GHz ; et
- une différence de gain inférieure à 0,4 dB ;
pour des signaux électriques dont la puissance monte jusqu'à 27 dBm.

L'invention permet en outre d'obtenir ces caractéristiques avantageuses tout en limitant l'encombrement du dispositif. En effet, la surface du support 22 présente une surface inférieure à 4 cm² ce qui est très inférieure à celle des dispositifs de l'état de la technique.

## Revendications

1. Dispositif (10) de traitement de signaux électriques à traiter, le traitement comprenant une division d'un signal électrique à diviser en signaux électriques divisés ou une combinaison de signaux électriques à combiner en un signal électrique combiné, comprenant :
- un support (20) ;
- un substrat (40) recouvrant au moins en partie le support (20) ;
- un module (60) de traitement de signaux électriques, agencé sur le substrat (40) ;
- une première borne (50) agencée sur le substrat (40) et connectée au module de traitement (60), la première borne (50) étant apte à recevoir un signal électrique à traiter par le module de traitement (60) ou à distribuer un signal électrique traité par le module de traitement (60) ;
- N deuxièmes bornes (52) agencées sur le substrat (40), N étant un entier supérieur ou égal à 5, chaque deuxième borne (52) étant connectée au module de traitement (60) et étant apte à recevoir un signal électrique à traiter par le module de traitement (60) ou à distribuer un signal électrique traité par le module de traitement (60) ;
le module de traitement (60) comprenant M étages (62) pour ledit traitement de signaux électriques successivement connectés entre la première borne (50) et les deuxièmes bornes (52), M étant un entier supérieur ou égal à 2,
un premier étage de traitement (62) comprenant un premier circuit intégré (64) pour ledit traitement de signaux électriques agencé sur le substrat (40) et connecté à la première borne (50) ; dans lequel pour K un entier compris entre 2 et M, le K-ième étage (62) comprend au moins un ensemble (66) de K-ièmes circuits intégrés (64) pour ledit traitement de signaux électriques agencés sur le substrat (40), les K-ièmes circuits intégrés (64) de respectivement chaque ensemble (66) étant connectés à un K-1-ième circuit intégré (64) respectif du K-1-ième étage (62),
chaque deuxième borne (52) étant connectée à un M-ième circuit intégré (64) pour ledit traitement de signaux électriques du M-ième étage (62),
**caractérisé en ce que** le support (20) présente une surface de support (22) sur laquelle le substrat (40), le module de traitement (60), la première borne (50) et les deuxièmes bornes (52) s'étendent, la surface de support (22) présentant :
- une portion centrale (24) en regard de laquelle les circuits intégrés (64) des M étages (62) pour ledit traitement de signaux électriques sont regroupés ;
- une portion annulaire (26) centrée sur la portion centrale (24), en regard de laquelle la première borne (50) et les deuxièmes bornes (52) sont agencées, les première (50) et deuxièmes (52) bornes étant réparties uniformément angulairement autour de la portion centrale (24) ;
la portion centrale (24) de la surface du support (22) présentant :
- une position centrale (28) sur laquelle le premier circuit intégré (64) est agencé ;
- M-1 cercles concentriques (30) centrés sur la position centrale (28) ;
dans lequel lorsque M est supérieur ou égal à 3 :
- pour P un entier compris entre 1 et M-2, le rayon du P+1-ième cercle (30) est supérieur au rayon du P-ième cercle concentrique (30) ;
- pour L un entier compris entre 1 et M-1, les L+1-ième circuits intégrés (64) du L+1-ième étage de traitement (62) sont agencés sensiblement sur le L-ième cercle concentrique (30).

2. Dispositif (10) selon la revendication 1, dans lequel les signaux électriques sont des signaux radiofréquence, notamment des signaux hyperfréquence, les signaux hyperfréquence présentant de préférence une fréquence comprise entre 2 MHz et 8 GHz.

3. Dispositif (10) selon la revendication 1 ou 2, dans lequel les circuits intégrés (64) sont des circuits intégrés monolithiques hyperfréquence configurés pour diviser ou combiner des signaux électriques.

4. Dispositif (10) selon l'une quelconque des revendications précédentes, comprenant en outre une pluralité de lignes (80) de transmission de signaux électriques gravées sur le substrat (40), chaque ligne (80) s'étendant entre un premier élément électronique (82) et un deuxième élément électronique (84),
le premier élément électronique (82) étant un circuit intégré (64),
le deuxième élément électronique (84) étant un autre circuit intégré (64), la première borne (50) ou une deuxième borne (52),
chaque ligne de transmission (80) présentant une longueur (L) mesurée entre les premier (82) et deuxième (84) éléments électroniques comprise entre 0,1 mm et 10 cm.

5. Dispositif (10) selon la revendication 4, dans lequel chaque ligne de transmission (80) présente une largeur (W) comprise entre 0,1 mm et 10,0 mm.

6. Dispositif (10) selon la revendication 4 ou 5, dans lequel chaque ligne de transmission (80) présente une épaisseur (H) comprise entre 1 µm et 1mm.

7. Dispositif (10) selon l'une quelconque des revendications précédentes, dans lequel le substrat (40) présente une épaisseur (E2) comprise entre 0,1 mm et 10,0 mm.

8. Dispositif (10) selon l'une quelconque des revendications précédentes, dans lequel le substrat (40) est réalisé en un matériau présentant une permittivité relative comprise entre 1,1 et 10,0, de préférence sensiblement égale à 3,7.

## Patentansprüche

1. Vorrichtung (10) zur Verarbeitung von zu verarbeitenden elektrischen Signalen, die Verarbeitung umfassend eine Aufteilung eines aufzuteilenden elektrischen Signals in aufgeteilte elektrische Signale oder eine Kombination von elektrischen Signalen zu einem kombinierten elektrischen Signal, umfassend:
- einen Träger (20);
- ein Substrat (40), das den Träger (20) zumindest teilweise bedeckt;
- ein Modul (60) zur Verarbeitung von elektrischen Signalen, das auf dem Substrat (40) angeordnet ist;
- einen ersten Anschluss (50), der auf dem Substrat (40) angeordnet und mit dem Verarbeitungsmodul (60) verbunden ist, wobei der erste Anschluss (50) geeignet ist, um ein elektrisches Signal zu empfangen, das von dem Verarbeitungsmodul (60) verarbeitet werden soll, oder um ein von dem Verarbeitungsmodul (60) verarbeitetes elektrisches Signal zu verteilen;
- N zweite Anschlüsse (52), die auf dem Substrat (40) angeordnet sind, wobei N eine ganze Zahl größer als oder gleich wie 5 ist, wobei jeder zweite Anschluss (52) mit dem Verarbeitungsmodul (60) verbunden ist und geeignet ist, um ein elektrisches Signal zu empfangen, das von dem Verarbeitungsmodul (60) verarbeitet werden soll, oder um ein von dem Verarbeitungsmodul (60) verarbeitetes elektrisches Signal zu verteilen;
das Verarbeitungsmodul (60) umfassend M Stufen (62) für die Verarbeitung elektrischer Signale,
die nacheinander zwischen dem ersten Anschluss (50) und den zweiten Anschlüssen (52) verbunden sind, wobei M eine ganze Zahl größer als oder gleich wie 2 ist,
eine erste Verarbeitungsstufe (62), umfassend eine erste integrierte Schaltung (64) für die Verarbeitung
elektrischer Signale, die auf dem Substrat (40) angeordnet ist und mit dem ersten Anschluss (50) verbunden ist; wobei K eine ganze Zahl zwischen 2 und M ist, die K-ten Stufe (62) mindestens einen Satz (66) von K-ten integrierten Schaltungen (64) für die Verarbeitung elektrischer Signale umfasst,
die auf dem Substrat (40) angeordnet sind, wobei die K-ten integrierten Schaltungen (64) jedes Satzes (66) jeweils mit einer entsprechenden (K-1)-ten integrierten Schaltung (64) der (K-1)-ten Stufe (62) verbunden sind,
wobei jeder zweite Anschluss (52) mit einer M-ten integrierten Schaltung (64) für die Verarbeitung
elektrischer Signale der M-ten Stufe (62) verbunden ist,
**dadurch gekennzeichnet, dass** der Träger (20) eine Trägerfläche (22) aufweist, auf der sich das Substrat (40), das Prozessmodul (60), der erste Anschluss (50) und die zweiten Anschlüsse (52) erstrecken, wobei die Trägerfläche (22) Folgendes aufweist:
- einen mittlerer Abschnitt (24), gegenüber dem die integrierten Schaltungen (64) der M-Stufen (62) für die Verarbeitung elektrischer Signale zusammengefasst sind;
- einen ringförmigen Abschnitt (26), der auf den mittleren Abschnitt (24) zentriert ist, gegenüber dem der erste Anschluss (50) und die zweiten Anschlüsse (52) angeordnet sind, wobei der erste Anschluss (50) und die zweiten Anschlüsse (52) gleichförmig um den mittleren Abschnitt (24) verteilt sind;
wobei der mittlere Abschnitt (24) der Oberfläche des Trägers (22) Folgendes aufweist:
- eine mittlere Position (28), an der die erste integrierte Schaltung (64) angeordnet ist;
- M-1 konzentrische Kreise (30), die auf der mittleren Position (28) zentriert sind;
wobei, wenn M größer als oder gleich wie 3 ist:
- für P, eine ganze Zahl zwischen 1 und M-2, der Radius des (P+1)-ten Kreises (30) größer als der des P-ten konzentrischen Kreises (30) ist;
- für L, eine ganze Zahl zwischen 1 und M-1, die (L+1)-ten integrierten Schaltungen (64) der (L+1)-ten Verarbeitungsstufe (62) im Wesentlichen auf dem L-ten konzentrischen Kreis (30) angeordnet sind.

2. Vorrichtung (10) nach Anspruch 1, wobei die elektrischen Signale Hochfrequenzsignale sind, insbesondere Mikrowellensignale, wobei die Mikrowellensignale vorzugsweise eine Frequenz zwischen 2 MHz und 8 GHz aufweisen.

3. Vorrichtung (10) nach Anspruch 1 oder 2, wobei die integrierten Schaltungen (64) monolithische integrierte Mikrowellenschaltungen sind, die zum Aufteilen oder Kombinieren von elektrischen Signalen konfiguriert sind.

4. Vorrichtung (10) nach einem der vorherigen Ansprüche, ferner umfassend eine Vielzahl von Leitungen (80) zum Übertragen von elektrischen Signalen, die in das Substrat (40) geätzt sind, wobei jede Leitung (80) zwischen einem ersten elektronischen Element (82) und einem zweiten elektronischen Element (84) verläuft,
wobei das erste elektronische Element (82) eine integrierte Schaltung (64) ist,
das zweite elektronische Element (84) eine weitere integrierte Schaltung (64), der erste Anschluss (50) oder ein zweiter Anschluss (52) ist,
jede Übertragungsleitung (80) eine zwischen dem ersten (82) und dem zweiten (84) elektronischen Element gemessene Länge (L) von 0,1 mm bis 10 cm aufweist.

5. Vorrichtung (10) nach Anspruch 4, wobei jede Übertragungsleitung (80) eine Breite (W) zwischen 0,1 mm und 10,0 mm aufweist.

6. Vorrichtung (10) nach Anspruch 4 oder 5, wobei jede Übertragungsleitung (80) eine Stärke (H) zwischen 1 µm und 1 mm aufweist.

7. Vorrichtung (10) nach einem der vorherigen Ansprüche, wobei das Substrat (40) eine Stärke (E2) zwischen 0,1 mm und 10,0 mm aufweist.

8. Vorrichtung (10) nach einem der vorherigen Ansprüche, wobei das Substrat (40) aus einem Material mit einer relativen Dielektrizitätskonstante zwischen 1,1 und 10,0, vorzugsweise im Wesentlichen gleich 3,7, gefertigt ist.

## Claims

1. A device (10) for processing electrical signals to be processed, the processing comprising a division of an electrical signal to be divided into divided electrical signals or a combination of electrical signals to be combined into a combined electrical signal, comprising:
- a support (20);
- a substrate (40) at least partially covering the support (20);
- a module (60) for processing electrical signals, arranged on the substrate (40);
- a first terminal (50) arranged on the substrate (40) and connected to the processing module (60), the first terminal (50) being able to receive an electrical signal to be processed by the processing module (60) or to distribute an electrical signal processed by the processing module (60);
- N second terminals (52) arranged on the substrate (40), N being an integer greater than or equal to 5, each second terminal (52) being connected to the processing module (60) and being able to receive an electrical signal to be processed by the processing module (60) or to distribute an electrical signal processed by the processing module (60);
the processing module (60) comprising M stages (62) for said processing of electrical signals successively connected between the first terminal (50) and the second terminals (52), M being an integer greater than or equal to 2,
a first processing stage (62) comprising a first integrated circuit (64) for said processing of electrical signals arranged on the substrate (40) and connected to the first terminal (50);
wherein for K, an integer comprised between 2 and M, the K-th stage (62) comprises at least one set (66) of K-th integrated circuits (64) for said processing of electrical signals arranged on the substrate (40), the K-th integrated circuits (64) of each set (66) being connected correspondingly to a respective K-1-th integrated circuit (64) of the K-1-th stage (62),
each second terminal (52) being connected to an M-th integrated circuit (64) for said processing of electrical signals of the M-th stage (62),
**characterized in that** the support (20) has a support surface (22) over which the substrate (40), the processing module (60), the first terminal (50) and the second terminals (52) extend, the support surface (22) having:
- a central portion (24) opposite which the integrated circuits (64) of the M stages (62) for said processing of electrical signals are grouped together;
- an annular portion (26) centered on the central portion (24), opposite which the first terminal (50) and the second terminals (52) are arranged, the first (50) and second (52) terminals being uniformly distributed angularly around the central portion (24);
the central portion (24) of the surface of the support (22) having:
- a central position (28) on which the first integrated circuit (64) is arranged;
- M-1 concentric circles (30) centered on the central position (28);
wherein when M is greater than or equal to 3:
- for P an integer comprised between 1 and M-2, the radius of the P+1-th circle (30) is greater than the radius of the P-th concentric circle (30);
- for L an integer comprised between 1 and M-1, the L+1-th integrated circuits (64) of the L+1-th stage (62) are arranged substantially on the L-th concentric circle (30).

2. The device (10) according to claim 1, wherein the electrical signals are radio frequency signals, in particular microwave frequency signals, the microwave frequency signals preferentially having a frequency between 2 MHz and 8 GHz.

3. The device (10) according to claim 1 or 2, wherein the integrated circuits (64) are monolithic microwave integrated circuits configured to divide or to combine electrical signals.

4. The device (10) according to any of the preceding claims, further comprising a plurality of transmission lines (80) for transmitting electrical signals, etched on the substrate (40), each transmission line (80) extending between a first electronic element (82) and a second electronic element (84),
the first electronic element (82) being an integrated circuit (64),
the second electronic element (84) being another integrated circuit (64), the first terminal (50) or a second terminal (52),
each transmission line (80) having a length (L) measured between the first (82) and second (84) electronic elements comprised between 0.1 mm and 10 cm.

5. The device (10) according to claim 4, wherein each transmission line (80) has a width (W) comprised between 0.1 mm and 10.0 mm.

6. The device (10) according to claim 4 or 5, wherein each transmission line (80) has a thickness (H) comprised between 1 µm and 1 mm.

7. The device (10) according to any of the preceding claims, wherein the substrate (40) has a thickness (E2) comprised between 0.1 mm and 10.0 mm.

8. The device (10) according to any of the preceding claims, wherein the substrate (40) is made of a material having a relative permittivity comprised between 1.1 and 10.0, preferably substantially equal to 3.7.
